# EUROPEAN PATENT APPLICATION

(11) **EP 2 632 122 A2**
(43) Date of publication of application: **28.08.2013**
(21) Application number: 13156500.4
(22) Date of filing: 25.02.2013
(51) Int. Cl.: H04M 1/02, H05K 5/04

(54) **Casing of handheld electronic device and method of manufacturing the same**

(30) Priority: 24.02.2012 US 201261602619 P; 04.10.2012 US 201213645486
(71) Applicant: HTC Corporation, Taoyuan County 330 (TW)
(72) Inventor: Chang, Feng-Chen, Taoyuan 330 Taoyuan City (TW); Chien, Chih-Ling, Taoyuan 330 Taoyuan City (TW)
(74) Representative: Konkonen, Tomi-Matti Juhani

(57) **Abstract**

A method of manufacturing a casing of a handheld electronic device includes following steps. A casing body and an oxidation metal layer are provided. The casing body is made of metal; the oxidation metal layer is located on a surface of the casing body. The oxidation metal layer is dyed by at least one dye and has an appearance with a color gradient through controlling the velocity of dyeing the oxidation metal layer by the dye. A casing of a handheld electronic device including a casing body and an oxidation metal layer is also provided. The casing body is made of metal. The oxidation metal layer is located on a surface of the casing body and dyed by at least one dye, so that an appearance of the oxidation metal layer has a color gradient.

## Description

### CROSS-REFERENCE TO RELATED APPLICATION

This application claims the priority benefits of U.S. provisional application serial no. 61/602,619, filed on February 24, 2012. The entirety of the above-mentioned patent application is hereby incorporated by reference herein and made a part of this specification.

### BACKGROUND

### Technical Field

The application relates to a casing and a method of manufacturing a casing. More particularly, the application relates to a casing of a handheld electronic device and a method of manufacturing a casing of a handheld electronic device.

### Description of Related Art

With recent advance of technology industry, users are able to at any time obtain the desired information from daily-used electronic devices. Besides, the electronic devices have been developing toward easy operation, multiple functionality, and pleasing appearance, so that users may have more and more choices. The increasing miniaturization of electronic devices also results in the growing demands for handheld electronic devices.

Handheld electronic devices including mobile phones, personal digital assistants (PDA), and smart phones are often characterized by compactness and light weight. Therefore, users may carry the handheld electronic devices with them and may use the handheld electronic devices with their hands.

However, casings of the handheld electronic devices are apt to be damaged by impact or scratched by sharp metal objects, e.g., keys. In another aspect, two ends of the casing of a handheld electronic device usually have the same color. Hence, when a user intends to grab the handheld electronic device whose casing faces upward, it is difficult for the user to visually distinguish the head portion of the handheld electronic device from the bottom portion.

### SUMMARY

The application is directed to a method of manufacturing a casing of a handheld electronic device. By applying the method, the casing may have favorable mechanical strength and may be visually recognized.

The application is also directed to a casing of a handheld electronic device that has favorable mechanical strength and is visually recognizable.

In an embodiment of the application, a method of manufacturing a casing of a handheld electronic device includes following steps. A casing body and an oxidation metal layer are provided. Here, a material of the casing body is metal, and the oxidation metal layer is located on a surface of the casing body. The oxidation metal layer is dyed by at least one dye and has a gradational appearance through controlling the velocity of dyeing the oxidation metal layer by the dye.

In an embodiment of the application, a casing of a handheld electronic device is further provided, and the casing includes a casing body and an oxidation metal layer. The casing body is made of metal. The oxidation metal layer is located on a surface of the casing body and dyed by at least one dye, so that the appearance of the oxidation metal layer has a color gradient.

In view of the above, according to the method of manufacturing the casing of the handheld electronic device described herein, the oxidation metal layer on the metallic casing body is dyed, such that the appearance of the oxidation metal layer may have the color gradient. In addition, the casing of the handheld electronic device described herein has the oxidation metal layer whose appearance has a color gradient, such that the head portion and the bottom portion of the casing are distinguishable. Thereby, the casing of the handheld electronic device has favorable mechanical strength and is visually recognizable.

In order to make the aforementioned and other features and advantages of the application more comprehensible, embodiments accompanying figures are described in detail below.

### BRIEF DESCRIPTION OF THE DRAWINGS

The accompanying drawings are included to provide a further understanding of the application, and are incorporated in and constitute a part of this specification. The drawings illustrate embodiments of the application and, together with the description, serve to explain the principles of the application.

FIG. 1 is a flow chart illustrating a method of manufacturing a casing of a handheld electronic device according to an embodiment of the application.

FIG. 2A to FIG. 2E are schematic cross-sectional views illustrating a method of manufacturing the casing of the handheld electronic device depicted in FIG. 1.

FIG. 3 is a schematic view illustrating a dyed oxidation metal layer according to an embodiment of the application.

FIG. 4 illustrates the correlation between a dyeing velocity and a dyeing distance of the oxidation metal layer depicted in FIG. 3.

FIG. 5 is a schematic view illustrating a dyed oxidation metal layer according to another embodiment of the application.

FIG. 6 illustrates the correlation between a dyeing velocity and a dyeing distance of the oxidation metal layer depicted in FIG. 5.

FIG. 7 illustrates the correlation between a dyeing velocity and a dyeing distance of an oxidation metal layer according to another embodiment of the application.

FIG. 8 illustrates the correlation between a dyeing velocity and a dyeing distance of an oxidation metal layer according to still another embodiment of the application.

### DESCRIPTION OF EMBODIMENTS

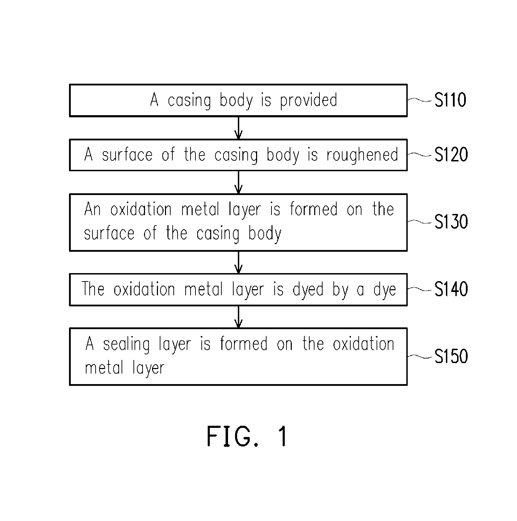

FIG. 1 is a flow chart illustrating a method of manufacturing a casing of a handheld electronic device according to an embodiment of the application[Donald1]. With reference to FIG. 1, in the present embodiment, a method of manufacturing a casing 100 of a handheld electronic device is described below. In step S110, a casing body 110 is provided. In step S120, a surface S1 of the casing body 110 is roughened. In step S130, an oxidation metal layer 120 is formed on the surface S1 of the casing body 110. In step S140, the oxidation metal layer 120 is dyed by a dye 102. In step S150, a sealing layer 130 is formed on the oxidation metal layer 120.

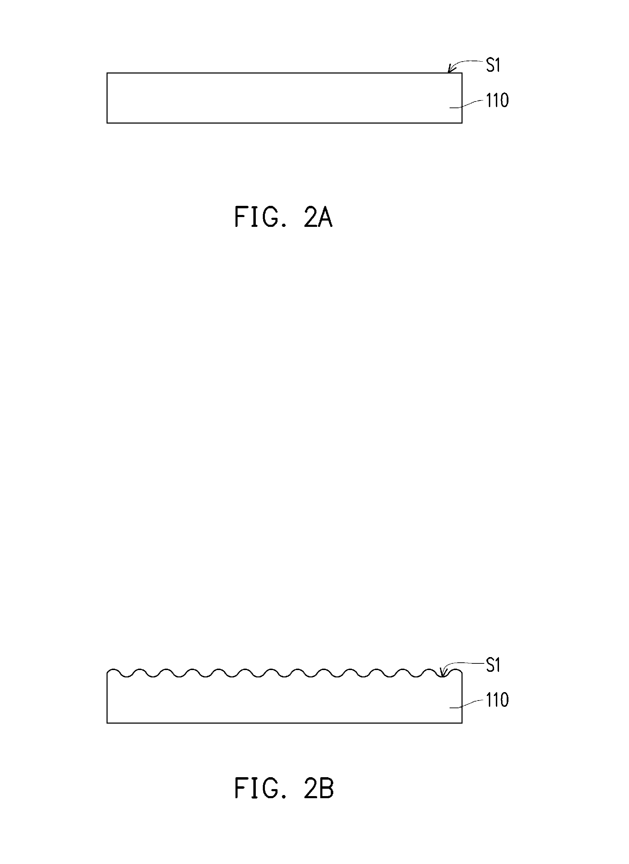

FIG. 2A to FIG. 2E are schematic cross-sectional views illustrating a method of manufacturing the casing of the handheld electronic device depicted in FIG. 1. According to the present embodiment, the casing 100 of the handheld electronic device is, for instance, a casing of a mobile phone or a casing of a smart phone, and the type of the handheld electronic device is not limited in the application. FIG. 2A to FIG. 2E sequentially illustrate the method of manufacturing the casing 100 of the handheld electronic device depicted in FIG. 1, and this method is described below with reference to FIG. 1 and FIG. 2A to FIG. 2E.

As shown in FIG. 1 and FIG. 2A, in step S110, a casing body 110 is provided. In this embodiment, the casing body 110 is made of metal, e.g., aluminum. However, in other embodiments of the application, the casing body 110 may be made of aluminum alloy or other types of metal, which should not be construed as a limitation to the application. Pre-treatment may be carried out on the casing body 110, e.g., the surface S1 of the casing body 110 may be cleaned, so as to remove the greasy dirt or dust on the surface S1.

As shown in FIG. 1 and FIG. 2B, in step S120, the surface S1 of the casing body 110 is roughened. According to the present embodiment, the surface S1 of the casing body 110 may be roughened by performing a sandblasting process or an evaporation process, such that the handheld electronic device may have a matte casing 100. Nevertheless, the application is not limited thereto; in other embodiments of the application, the casing body 110 may have a roughened surface S1 formed by performing other processes, or the surface S1 is not roughened. The application does not pose any limitation on whether the surface S1 is roughened nor the way to roughen the surface S1.

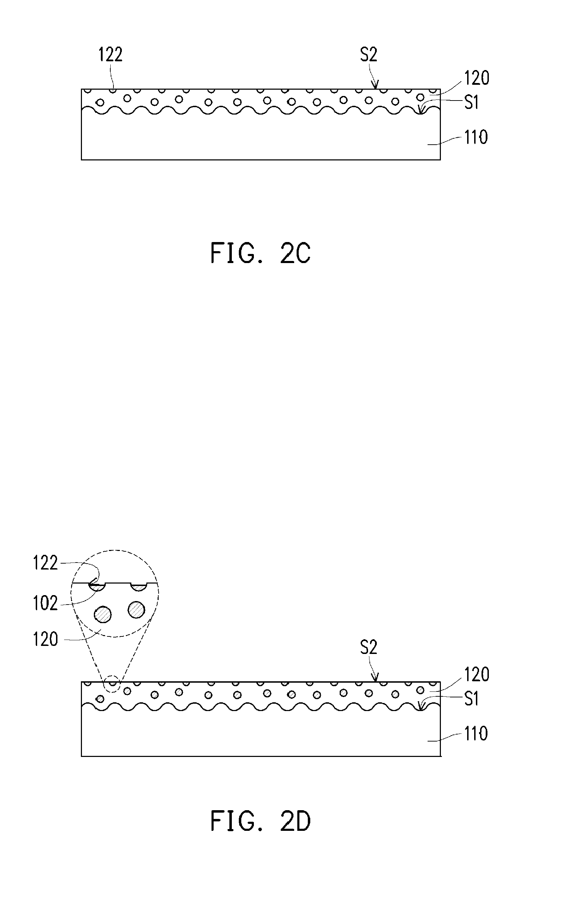

As shown in FIG. 1 and FIG. 2C, in step S130, the oxidation metal layer 120 is formed on the surface S1 of the casing body 110. In the present embodiment, the surface S1 of the casing body 110 is already roughened, and the oxidation metal layer 120 is formed on the roughened surface S1. As such, the oxidation metal layer 120 may have a smooth surface S2. However, in another embodiment of the application, the oxidation metal layer 120 may also be formed on the non-roughened surface S1 of the casing body 110, which should not be construed as a limitation to the application.

According to the present embodiment, the oxidation metal layer 120 is formed on the surface S1 of the casing body 110 by performing an anodizing process. The anodizing process refers to a surface treatment technology. Surface treatment is frequently carried out to change and improve physical, mechanical, and chemical properties of surfaces of metallic materials. For instance, materials that undergo the surface treatment may be more resistant to corrosion, more resistant to abrasion, more resistant to heat, and more electrically conductive, such that the life spans of the materials may be extended, or that the materials may have smooth and pleasant look.

Through the surface treatment, a protection coating may be formed on a surface of the metallic material, and the protection coating may, based on the type of the material, be categorized into inorganic coating and organic coating. The inorganic coating includes conversion coating that is made of metal, glass, or ceramic and made by performing the anodizing process. Here, the conversion coating is an oxidation metal layer comprising the metallic material, which is formed on the surface of the metallic material by chemical treatment or electrochemical treatment. The organic coating includes paint, resin, paraffin, ointment, rubber, asphalt, etc. Each protection coating has its own characteristics and usage, and the anodizing process may be performed to provide a protective oxidation metal layer (with the dense texture) to the metallic material.

Specifically, by performing the anodizing process, the oxidation metal layer based on the metallic material may be formed on a surface of a metallic object to enhance the mechanical strength of the metallic object. Besides, the anodizing process allows inner layers of the metallic object to be colored. In the anodizing process, the metallic object is placed at the anode in an electrolytic cell, and voltages and currents may be applied, such that the oxidation metal layer may be well attached to the surface of the metallic object.

In the present embodiment, a material of the casing body 110 is aluminum, and thus the oxidation metal layer 120 formed on the surface S1 of the casing body 110 by performing the anodizing process is made of aluminum oxide. The oxidation metal layer 120 that undergoes the anodizing process has fine micro-pores 122, such that the oxidation metal layer 120 may have a matte surface and a roughened touch[Donald2].

Besides, after the oxidation metal layer 120 is formed on the surface S1 of the casing body 110 by performing the anodizing process, anodizing pre-treatment may be carried out on the casing body 110, so as to remove surface defects, e.g., dust, oxide, greasy dirt, fingerprints caused by transportations, metal burrs, slight scratches, and so on. The anodizing pre-treatment may include a de-oiling step, an alkaline liquid etching step, a chemical polishing step, an activation step, and so on. Appropriate steps of the anodizing pre-treatment may be determined according to the properties of the material and the actual requirements and should not be construed as limitations to the application.

As shown in FIG. 1 and FIG. 2D, in step S140, the oxidation metal layer 120 is dyed by the dye 102, and an appearance of the oxidation metal layer 120 has a color gradient through controlling a velocity of dyeing the oxidation metal layer 120 by the dye 102. In the present embodiment, the step of dyeing the oxidation metal layer 120 includes immersing the casing body 110 and the oxidation metal layer 120 in a dyeing chamber, and a velocity of immersing the casing body 110 and the oxidation metal layer 120 in the dyeing chamber is controlled. The dye 102 is attached to the fine micro-pores 122 of the oxidation metal layer 120 within different time frames, and therefore the appearance of the oxidation metal layer 120 has a color gradient.

In particular, by controlling certain instruments, the casing body 110 may be immersed in the dyeing chamber from one end of the casing body 110 to the other end of the casing body 110, such that the dye 102 is gradually absorbed by the fine micro-pores 122 on the surface S2 of the oxidation metal layer 120. The longer the oxidation metal layer 120 is immersed in the dyeing chamber, the darker the color of the dyed oxidation metal layer 120 is. Hence, immersion of the oxidation metal layer 120 in the dyeing chamber may cause the appearance of the dyed oxidation metal layer 120 to have different color gradients.

Besides, the velocity of immersing the casing body 110 and the oxidation metal layer 120 in the dyeing chamber may be controlled by controlling certain instruments. The velocity of immersing the oxidation metal layer 120 in the dyeing chamber is relevant to the color gradient level of the appearance of the oxidation metal layer 120. Hence, based on different requirements for the appearance of the oxidation metal layer 120, the velocity of immersing the oxidation metal layer 120 in the dyeing chamber may be properly determined. In addition, the velocity of immersing different sections of the oxidation metal layer 120 in the dyeing chamber may be changed, such that the color gradient level of the appearance of the oxidation metal layer 120 may also alter.

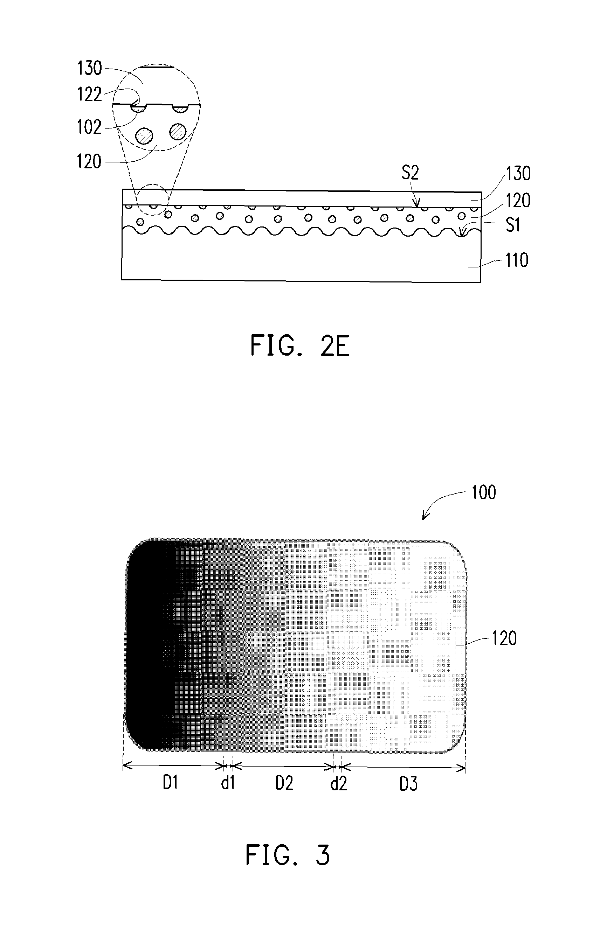

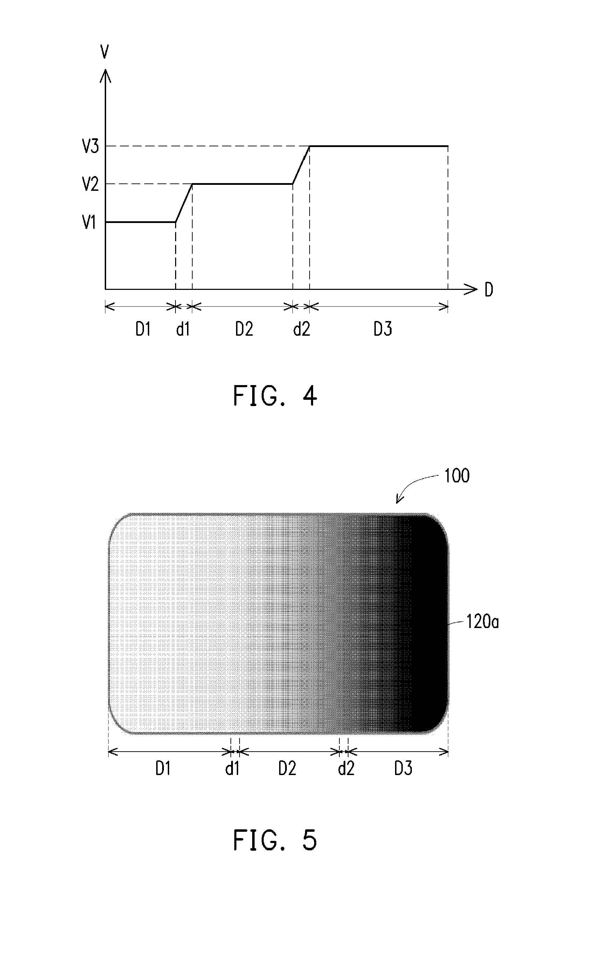

FIG. 3 is a schematic view illustrating a dyed oxidation metal layer according to an embodiment of the application. FIG. 4 illustrates the correlation between a dyeing velocity and a dyeing distance of the oxidation metal layer depicted in FIG. 3. With reference to FIG. 3 and FIG. 4, in the present embodiment, the velocity of immersing the oxidation metal layer 120 in the dyeing chamber may be changed by the immersion depth (i.e., the dyeing distance) of the oxidation metal layer 120.

In particular, the oxidation metal layer 120 has a first dyeing section D1, a second dyeing section D2, a third dyeing section D3, a cushioning section d1 between the first and second dyeing sections D1 and D2, and a cushioning section d2 between the second and third dyeing sections D2 and D3. By dividing the oxidation metal layer 120 into plural dyeing sections and immersing the dyeing sections in the dyeing chamber in various constant velocities, the color gradient level of the appearance of the oxidation metal layer 120 is allowed to be different.

Accordingly, in the present embodiment, a method of controlling the velocity of immersing the oxidation metal layer 120 in the dyeing chamber is described below. The first dyeing section D1 is first immersed in the dyeing chamber in a first constant velocity V1. After the first dyeing section D1 is completely immersed in the dyeing chamber, the cushioning section d1 is immersed in the dyeing chamber in a constant acceleration A1. After the first dyeing section D1 and the cushioning section d1 are completely immersed in the dyeing chamber, the second dyeing section D2 is immersed in the dyeing chamber in a second constant velocity V2. Here, an initial velocity of the constant acceleration A1 is equal to the first constant velocity V1, and a final velocity of the constant acceleration A1 is equal to the second constant velocity V2.

Similarly, after the second dyeing section D2 is completely immersed in the dyeing chamber, the cushioning section d2 is immersed in the dyeing chamber in a constant acceleration A2. After the second dyeing section D2 and the cushioning section d2 are completely immersed in the dyeing chamber, the third dyeing section D3 is immersed in the dyeing chamber in a third constant velocity V3. Here, an initial velocity of the constant acceleration A2 is equal to the second constant velocity V2, and a final velocity of the constant acceleration A2 is equal to the third constant velocity V3.

After the oxidation metal layer 120 is completely dyed, the oxidation metal layer 120 need be rapidly moved out of the dyeing chamber, and a water cleansing process is then performed. Thereby, the time frame during which the dye 102 is attached to the surface S2 of the oxidation metal layer 120 is relatively short, so as to prevent parts of the oxidation metal layer 120 from having dark color or prevent the dye 102 from leaving a flow trace on the oxidation metal layer 120.

The completely dyed oxidation metal layer 120 is shown in FIG. 3. The first dyeing section D1 of the oxidation metal layer 120 is immersed in the dyeing chamber for a longest time and thus has the darkest color. The third dyeing section D3 of the oxidation metal layer 120 is immersed in the dyeing chamber for a shortest time and thus has the lightest color. The color gradient level of the second dyeing section D2 ranges between that of the first dyeing section D1 and that of the third dyeing section D3.

In light of the foregoing, during the process of changing the constant velocity of immersing the oxidation metal layer 120, changes to the color gradient level of adjacent dyeing sections may be determined by the amount of acceleration. For instance, if the amount of acceleration is excessively large, variations to the color gradient level of adjacent dyeing sections are significant. Therefore, by properly adjusting the acceleration or switching between different constant velocities, the changes to the color gradient level of adjacent dyeing sections become insignificant. Besides, in the present embodiment, three dyeing sections and two cushioning sections are provided, while the number of the dyeing sections of the oxidation metal layer 120 may be changed in other embodiments of the application.

From another perspective, according to another embodiment of the application, the step S140 shown in FIG. 2D includes moving the oxidation metal layer 120 out of the dyeing chamber and controlling a velocity of moving the oxidation metal layer 120 out of the dyeing chamber.

To be specific, through rapidly moving the casing body 110 into the dyeing chamber and controlling certain instruments to move the casing body 110 out of the dyeing chamber from one end of the casing body 110 to the other end of the casing body 110, the dye 102 may be gradually absorbed by the fine micro-pores 122 on the surface S2 of the oxidation metal layer 120. The longer the oxidation metal layer 120 is immersed in the dyeing chamber, i.e., the later the oxidation metal layer 120 is moved out of the dyeing chamber, the darker the color of the dyed oxidation metal layer 120 is. Hence, movement of the oxidation metal layer 120 out of the dyeing chamber may cause the appearance of the dyed oxidation metal layer 120 to have different color gradients.

On the other hand, the velocity of moving the oxidation metal layer 120 out of the dyeing chamber is relevant to the color gradient level of the appearance of the oxidation metal layer 120. Hence, based on different requirements for the appearance of the oxidation metal layer 120, the velocity of moving the oxidation metal layer 120 out of the dyeing chamber may be properly determined. In addition, the velocity of moving different sections of the oxidation metal layer 120 out of the dyeing chamber may be changed, such that the color gradient level of the appearance of the oxidation metal layer 120 may also alter.

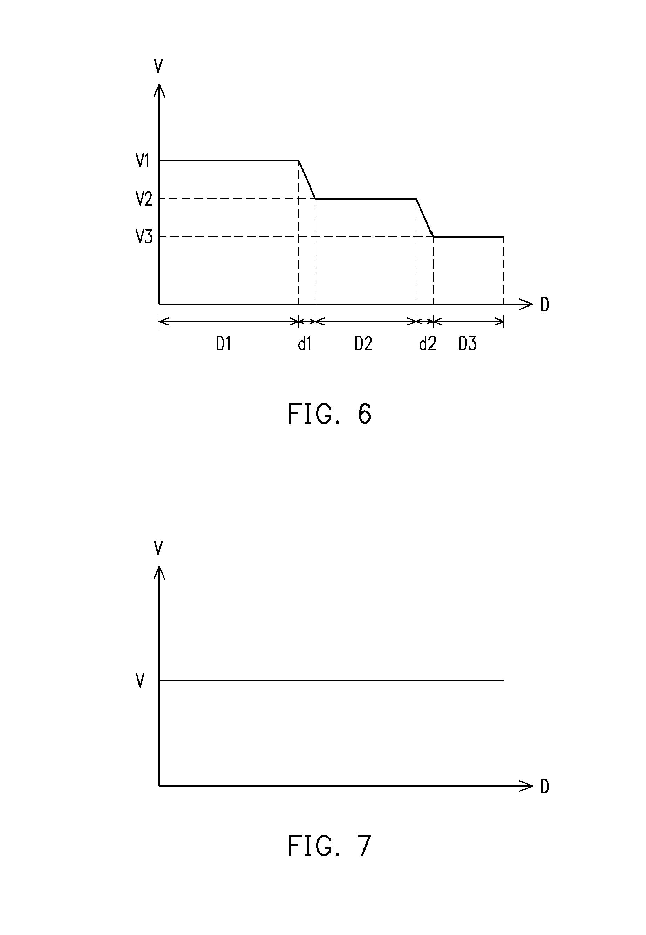

FIG. 5 is a schematic view illustrating a dyed oxidation metal layer according to another embodiment of the application. FIG. 6 illustrates the correlation between a dyeing velocity and a dyeing distance of the oxidation metal layer depicted in FIG. 5. With reference to FIG. 5 and FIG. 6, in the present embodiment, the oxidation metal layer 120a has a first dyeing section D1, a second dyeing section D2, a third dyeing section D3, a cushioning section d1 between the first and second dyeing sections D1 and D2, and a cushioning section d2 between the second and third dyeing sections D2 and D3. By dividing the oxidation metal layer 120a into plural dyeing sections and moving the dyeing sections out of the dyeing chamber in various constant velocities, the color gradient level of the appearance of the oxidation metal layer 120a is allowed to be different.

According to the present embodiment, a method of controlling the velocity of moving the oxidation metal layer 120a out of the dyeing chamber is described below. Firstly, the first dyeing section D1 is moved out of the dyeing chamber in a first constant velocity V1. After the first dyeing section D1 is completely moved out of the dyeing chamber, the cushioning section d1 is moved out of the dyeing chamber in a constant acceleration A1. After the first dyeing section D1 and the cushioning section d1 are completely moved out of the dyeing chamber, the second dyeing section D2 is moved out of the dyeing chamber in a second constant velocity V2. Here, an initial velocity of the constant acceleration A1 is equal to the first constant velocity V1, and a final velocity of the constant acceleration A1 is equal to the second constant velocity V2.

Similarly, after the second dyeing section D2 is completely moved out of the dyeing chamber, the cushioning section d2 is moved out of the dyeing chamber in a constant acceleration A2. After the second dyeing section D2 and the cushioning section d2 are completely moved out of the dyeing chamber, the third dyeing section D3 is moved out of the dyeing chamber in a third constant velocity V3. Here, an initial velocity of the constant acceleration A2 is equal to the second constant velocity V2, and a final velocity of the constant acceleration A2 is equal to the third constant velocity V3.

After the oxidation metal layer 120a is completely dyed, a water cleansing process may be rapidly performed on the oxidation metal layer 120a, so as to prevent parts of the oxidation metal layer 120a from having dark color or prevent the dye 102 from leaving a flow trace on the oxidation metal layer 120a. The completely dyed oxidation metal layer 120a is shown in FIG. 5. The first dyeing section D1 of the oxidation metal layer 120a is first moved out of the dyeing chamber and thus has the lightest color. The third dyeing section D3 of the oxidation metal layer 120a is last moved out of the dyeing chamber and thus has the darkest color. The color gradient level of the second dyeing section D2 ranges between that of the first dyeing section D1 and that of the third dyeing section D3.

As described in the above embodiments, when the color gradient of the appearance of the oxidation metal layer 120 and that of the oxidation metal layer 120a are changed along a length direction of the casing body 110, two ends (head and bottom portions) of the casing body 110 may have different shades, such that the two ends of the casing body 110 are distinguishable, as shown in FIG. 3 and FIG. 5. Thereby, the oxidation metal layers 120 and 120a whose appearance have the color gradients allow the head portion and the bottom portion of the casing 100 of the handheld electronic device having the casing body 110 to be distinguishable. Namely, the head portion and the bottom portion of the casing 100 of the handheld electronic device may be distinguished from each other by observing the color of the appearance of the oxidation metal layers 120 and 120a from dark to light or from light to dark. Besides, by controlling the dyeing velocity in the steps of dyeing the oxidation metal layers 120 and 120a, the color gradient of the appearance of the oxidation metal layers 120 and 120a may be changed in a non-linear manner, such that the oxidation metal layers 120 and 120a may create special visual effects.

FIG. 7 illustrates the correlation between a dyeing velocity and a dyeing distance of an oxidation metal layer according to another embodiment of the application. With reference to FIG. 7, in other embodiments of the application, the step of controlling the velocity of immersing the oxidation metal layer 120 in the dyeing chamber or moving the oxidation metal layer 120 out of the dyeing chamber includes immersing the oxidation metal layer 120 in the dyeing chamber or moving the oxidation metal layer 120 out of the dyeing chamber in a constant velocity V. By immersing the oxidation metal layer 120 in the dyeing chamber or moving the oxidation metal layer 120 out of the dyeing chamber from one end of the casing body 110 to the other end of the casing body 110 in the constant velocity V, the color gradient level of the appearance of the oxidation metal layer 120 is allowed to be constant.

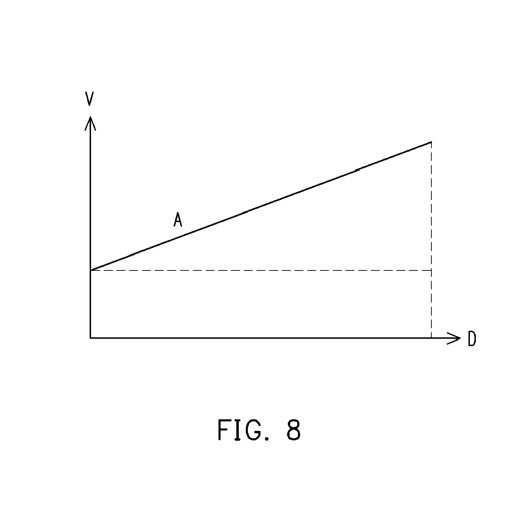

FIG. 8 illustrates the correlation between a dyeing velocity and a dyeing distance of an oxidation metal layer according to still another embodiment of the application. With reference to FIG. 8, in other embodiments of the application, the step of controlling the velocity of immersing the oxidation metal layer 120 in the dyeing chamber or moving the oxidation metal layer 120 out of the dyeing chamber includes immersing the oxidation metal layer 120 in the dyeing chamber or moving the oxidation metal layer 120 out of the dyeing chamber in a constant acceleration A. By immersing the oxidation metal layer 120 in the dyeing chamber or moving the oxidation metal layer 120 out of the dyeing chamber from one end of the casing body 110 to the other end of the casing body 110 in the constant acceleration A, the color gradient level of the appearance of the oxidation metal layer 120 may gradually increase or decrease from one end of the casing body 110 to the other end of the casing body 110.

Nevertheless, in another embodiment of the application, the oxidation metal layer 120 may be immersed in or moved out of the dyeing chamber in an irregular velocity, which should not be construed as a limitation to the application. Additionally, in the present embodiment, the velocity of immersing the oxidation metal layer 120 in the dyeing chamber or moving the oxidation metal layer 120 out of the dyeing chamber is controlled by adjusting the distance of immersing the oxidation metal layer 120 in the dyeing chamber or moving the oxidation metal layer 120 out of the dyeing chamber. In other embodiments of the application, the velocity of immersing the oxidation metal layer 120 in the dyeing chamber or moving the oxidation metal layer 120 out of the dyeing chamber may also be determined by other control factors, e.g., time, which should not be construed as a limitation to the application.

According to an embodiment of the application, the step of dyeing the oxidation metal layer 120 by the dye 102 includes sequentially dyeing the oxidation metal layer 120 by a plurality of dyes. These dyes are respectively located at a plurality of dyeing chambers and have different colors. Hence, the oxidation metal layer 120 on the casing body 110 may be immersed in the dyeing chambers or moved out of the dyeing chambers, such that the oxidation metal layer 120 may be sequentially dyed by the dyes. Besides, through controlling the velocity of dyeing the oxidation metal layer 120 by one of the dyes, the appearance of the oxidation metal layer 120 may have one signal color, and through controlling the velocity of dyeing the oxidation metal layer 120 by each of the dyes, the appearance of the oxidation metal layer 120 may have the color gradient (in multiple colors). The number of the dyes is not limited in the application.

When the color gradient of the appearance of the oxidation metal layer 120 in different colors is changed along a length direction of the casing body 110, two ends (head and bottom portions) of the casing body 110 may have different colors (i.e., the color of the casing body 110 is gradually changed from the head portion to the bottom portion of the casing body 110), such that the two ends of the casing body 110 are in different colors. Thereby, the oxidation metal layer 120 whose appearance has a color gradient allows the head portion and the bottom portion of the casing 100 of the handheld electronic device having the casing body 110 to be distinguishable, and a user may, by observing the color change of the casing body 110, distinguish the head portion of the casing 100 from the bottom portion of the casing 100.

As shown in FIG. 1 and FIG. 2E, in step S150, a sealing layer 130 is formed on the oxidation metal layer 120, and the sealing layer 130 seals the dye 102 onto the surface S2 of the oxidation metal layer 120. According to the present embodiment, after the oxidation metal layer 120 is dyed, the casing 100 of the handheld electronic device is substantially formed. Hence, the surface S2 of the oxidation metal layer 120 may be in contact with a user's hand. The surface S2 of the oxidation metal layer 120 has the fine micro-pores 122, such that the oxidation metal layer 120 may have a roughened texture, and that the dye 102 located in the fine micro-pores 122 on the surface S2 may lose color because of the contact with users.

Hence, through forming the sealing layer 130 on the oxidation metal layer 120, it is not the oxidation metal layer 120 but the sealing layer 130 that is in contact with a user. Since the sealing layer 130 is capable of sealing the dye 102 onto the surface S2 of the oxidation metal layer 120, the dye 102 does not lose color because of the contact with users. In addition, a surface of the sealing layer 130 is smoother than the surface of the oxidation metal layer 120. Therefore, after the casing 100 of the handheld electronic device is formed, the surface of the casing 100 is rather smooth, and the appearance of the oxidation metal layer 120 with the color gradient may be protected because the dye 102 is sealed into the fine micro-pores 122 on the surface of the oxidation metal layer 120.

According to the present embodiment, after the sealing layer 130 is formed on the oxidation metal layer 120, a water cleansing process and a drying process may be performed on the casing 100 of the handheld electronic device, such that the casing 100 of the handheld electronic device may have the appearance with the color gradient. The water cleansing process may be performed between each of the aforesaid steps, such that the reaction in one of the steps does not interfere with the reaction in another of the steps. However, the application is not limited thereto.

With reference to FIG. 2E, the casing 100 of the handheld electronic device includes the casing body 110, the oxidation metal layer 120, and the sealing layer 130. The oxidation metal layer 120 is located on the surface S1 of the casing body 110 and has the appearance with the color gradient, and the surface S1 of the casing body 110 is a roughened surface. The sealing layer 130 is located on the oxidation metal layer 120, and the surface of the sealing layer 130 is smoother than the surface of the oxidation metal layer 120.

As described above, the casing 100 of the handheld electronic device may have a double-layer structure constituted by the metallic casing body 110 and the oxidation metal layer 120. The casing of the conventional handheld electronic device is often cracked or deformed due to the impact thereon. By contrast, the casing 100 of the handheld electronic device has the oxidation metal layer 120 which may enhance the mechanical strength of the casing 100 of the handheld electronic device. Moreover, in the casing 100 of the handheld electronic device, the oxidation metal layer 120 is dyed and thus has the appearance with the color gradient, and the sealing layer 130 is capable of protecting the appearance (with color gradient) of the oxidation metal layer 120, such that the casing 100 of the handheld electronic device is visually recognizable.

To sum up, according to the method of manufacturing the casing of the handheld electronic device, the oxidation metal layer on the metallic casing body is dyed, such that the appearance of the oxidation metal layer may have the color gradient. In addition, the casing of the handheld electronic device provided herein includes the casing body on which the oxidation metal layer and the sealing layer are formed. The oxidation metal layer enhances the mechanical strength of the casing of the handheld electronic device, and the sealing layer ensures the oxidation metal layer to have the appearance with the color gradient. Thereby, after applying the method of manufacturing the casing of the handheld electronic device, the casing may have favorable mechanical strength and may be visually recognized.

Although the application has been described with reference to the above embodiments, it will be apparent to one of the ordinary skill in the art that modifications to the described embodiment may be made without departing from the spirit of the application. Accordingly, the scope of the application will be defined by the attached claims not by the above detailed descriptions.

## Claims

1. A method of manufacturing a casing of a handheld electronic device, the method comprising:
providing a casing body, wherein a material of the casing body being metal ;
forming an oxidation metal layer on the surface of the casing body, wherein the step of forming the oxidation metal layer comprises performing an anodizing process; and
dyeing the oxidation metal layer by at least one dye, wherein an appearance of the oxidation metal layer has a color gradient through controlling a velocity of dyeing the oxidation metal layer by the at least one dye.

2. The method as recited in claim 1, further comprising:
roughening the surface of the casing body before forming the oxidation metal layer.

3. The method as recited in claim 1, wherein the step of dyeing the oxidation metal layer by the at least one dye comprises controlling a velocity of immersing the oxidation metal layer in a dyeing chamber, so as to control the velocity of dyeing the oxidation metal layer by the at least one dye.

4. The method as recited in claim 3, wherein the step of controlling the velocity of immersing the oxidation metal layer in the dyeing chamber comprises immersing the oxidation metal layer in the dyeing chamber in a constant velocity.

5. The method as recited in claim 3, wherein the oxidation metal layer has a first dyeing section, a second dyeing section, and a cushioning section between the first dyeing section and the second dyeing section, and the step of controlling the velocity of immersing the oxidation metal layer in the dyeing chamber comprises:
immersing the first dyeing section in the dyeing chamber in a first constant velocity;
after the first dyeing section is completely immersed in the dyeing chamber, immersing the cushioning section in the dyeing chamber in a constant acceleration; and
after the first dyeing section and the cushioning section are completely immersed in the dyeing chamber, immersing the second dyeing section in the dyeing chamber in a second constant velocity, wherein an initial velocity of the constant acceleration is equal to the first constant velocity, and a final velocity of the constant acceleration is equal to the second constant velocity.

6. The method as recited in claim 1, wherein the step of dyeing the oxidation metal layer by the at least one dye comprises controlling a velocity of moving the oxidation metal layer out of a dyeing chamber, so as to control the velocity of dyeing the oxidation metal layer by the at least one dye.

7. The method as recited in claim 6, wherein the step of controlling the velocity of moving the oxidation metal layer out of the dyeing chamber comprises moving the oxidation metal layer out of the dyeing chamber in a constant velocity.

8. The method as recited in claim 6, wherein the oxidation metal layer has a first dyeing section, a second dyeing section, and a cushioning section between the first dyeing section and the second dyeing section, and the step of controlling the velocity of moving the oxidation metal layer out of the dyeing chamber comprises:
moving the first dyeing section out of the dyeing chamber in a first constant velocity;
after the first dyeing section is completely moved out of the dyeing chamber, moving the cushioning section out of the dyeing chamber in a constant acceleration; and
after the first dyeing section and the cushioning section are completely moved out of the dyeing chamber, moving the second dyeing section out of the dyeing chamber in a second constant velocity, wherein an initial velocity of the constant acceleration the is equal to the first constant velocity, and a final velocity of the constant acceleration is equal to the second constant velocity.

9. The method as recited in claim 1, wherein the step of dyeing the oxidation metal layer by the at least one dye comprises sequentially dyeing the oxidation metal layer by a plurality of dyes respectively located at a plurality of dyeing chambers and having different colors, the appearance of the oxidation metal layer has the color gradient through controlling a velocity of sequentially dyeing the oxidation metal layer by the dyes, and the step of sequentially dyeing the oxidation metal layer by the dyes comprises sequentially immersing the oxidation metal layer in the dyeing chambers or sequentially moving the oxidation metal layer out of the dyeing chambers.

10. The method as recited in claim 1, further comprising:
forming a sealing layer on the oxidation metal layer after dyeing the oxidation metal layer by the at least one dye, wherein the sealing layer seals the at least one dye onto a surface of the oxidation metal layer and a surface of the sealing layer is smoother than the surface of the oxidation metal layer.

11. A casing of a handheld electronic device, the casing comprising:
a casing body, a material of the casing body being metal; and
an oxidation metal layer located on a surface of the casing body and dyed by at least one dye, such that an appearance of the oxidation metal layer has a color gradient.

12. The casing of the handheld electronic device as recited in claim 11, wherein the color gradient of the appearance of the oxidation metal layer is changed along a length direction of the casing body, such that two ends of the casing body have different colors or shades, and that the two ends of the casing body are distinguishable.

13. The casing of the handheld electronic device as recited in claim 11, wherein the surface of the casing body is a roughened surface.

14. The casing of the handheld electronic device as recited in claim 11, wherein the oxidation metal layer dyed by a plurality of dyes has the appearance with the color gradient and in different colors.

15. The casing of the handheld electronic device as recited in claim 11, further comprising:
a sealing layer located on the oxidation metal layer, wherein the sealing layer seals the at least one dye onto a surface of the oxidation metal layer and a surface of the sealing layer is smoother than the surface of the oxidation metal layer.
